# EUROPEAN PATENT SPECIFICATION

(11) **EP 1 768 187 B1**
(45) Date of publication and mention of the grant of the patent: **26.03.2008**
(21) Application number: 05020925.3
(22) Date of filing: 26.09.2005
(51) Int. Cl.: H01L 27/24, G11C 13/02, G11C 16/02

(54) **Microelectronic device with storage elements and method of producing the same**
Mikroelektronische Vorrichtung mit Speicherelementen und Verfahren zu ihrer Herstellung
Dispositif microélectronique ayant des éléments de mémoire et son procédé de fabrication

(43) Date of publication of application: 28.03.2007
(73) Proprietor: Qimonda AG, 81739 München (DE)
(72) Inventor: Röhr, Thomas, 85609 Aschheim (DE)
(74) Representative: Patentanwaltskanzlei WILHELM & BECK

(56) References cited:
- EP-A- 1 429 342
- WO-A-20/05117026
- US-A1- 2002 097 598
- US-A1- 2003 137 869
- US-A1- 2004 017 706
- US-A1- 2004 056 286
- MULLER G ET AL: "Status and outlook of emerging nonvolatile memory technologies" IEDM TECHNICAL DIGEST 2004, SAN FRANCISCO, CA, USA, DEC. 13-15, 2004; PISCATAWAY, NJ, USA, IEEE, 13 December 2004 (2004-12-13), pages 567-570, XP010788850 ISBN: 0-7803-8684-1

## Description

### Background of the invention

### 1. Field of the invention

The present invention refers to a microelectronic device comprising a plurality of storage elements in a chain architecture and a method of manufacturing such a microelectronic device. Each storage element comprises a storing material between two electrodes. The storing material provides at least two different storing states with different electrical properties. According to one embodiment, the two electrodes of the storage element comprise two different materials. According to another embodiment, the storing material is a resistive storing material, wherein the at least two different storing states are resistive states with different resistance values.

### 2. Description of the related art

Non-volatile memory devices are able to store information without the need of any power supply. For this reason they are very advantageous for many applications, particularly in mobile devices operating a maximum time with a minimum of energy stored in a tiny battery. Similar to other microelectronic devices, the microscopic structures of non-volatile memory devices are constantly miniaturized thereby increasing the storage capacity of the device and lowering its manufacturing costs.

There is a number of different concepts and physical phenomena current and future non-volatile memory devices are based on. In PCRAMs (PCRAM = Phase Change Random Access Memory) each storage element comprises a chalcogenide alloy (for example Ge₂Sb₂Te₅) or any other material which is switched between a highly resistive amorphous state and a low resistive crystalline state.

In a CBRAM (CBRAM = Conductive Bridging Random Access Memory), each storage element is a conductive bridging junction (CBJ; further known as PMC = Programmable Metallization Cell). An electrically insulating matrix material comprising small regions or islands of electrically conductive material is arranged between two electrodes. One of these electrodes is chemically inert. Throughout this application, an electrode is called chemically inert if its chemical state is not altered in the process of programming of the storage element. The other electrode comprises an electrochemically active material. A voltage across the storage element above a predefined threshold drives material from the active electrode into the insulating matrix thereby increasing the conductive islands which finally form a conductive bridge across the storage element between the electrodes. This conductive bridge reduces the electrical resistance of the storage element by several orders of magnitude. A voltage with reversed polarity across the storage element drives patterns of the conductive island back to the active electrode thereby reducing the conductive islands, destroying the conductive bridge and increasing the electrical resistance of the storage element by several orders of magnitude.

An advantageous architecture of memory devices with resistive storage elements is the so called NAND or chain architecture. A number of storage elements (for example 8, 16 or 32) are connected in series. A transistor is connected in parallel to each single storage element forming a switchable bypass. For the access to a certain one of the storage elements, the bypass transistor of this certain storage element is in a highly resistive OFF-state while all the other transistors are in a highly conductive ON-state thereby bypassing their respective storage elements. In this way, the voltage applied to the chain of storage elements or a current flowing through the chain solely affect the selected one of the storage elements.

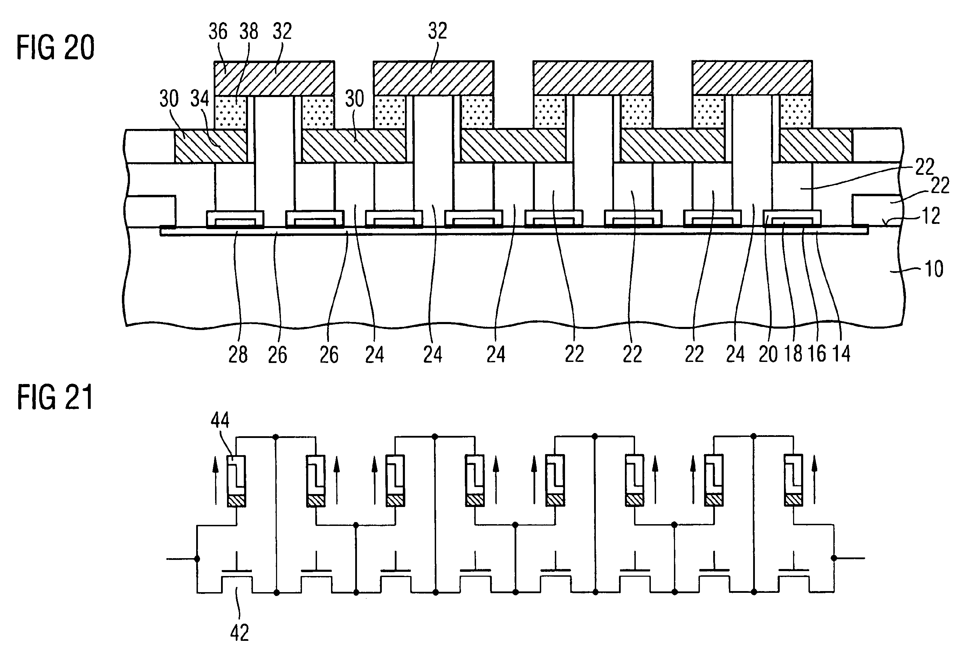

Figure 20 displays a schematic view of a vertical section across a chain of eight CBJ storage elements in a conventional memory device. Figure 21 displays a schematic circuit diagram of the chain. The device comprises a substrate 10 with a surface 12. An active area 14 is formed at the surface 12 of the substrate 10. Gate oxide layers 16 electrically insulate word lines 18 from the active area 14. The word lines 18 are covered by a thin electrically insulating layer 20. A thick electrically insulating layer 22 is deposited over the surface 12 of a substrate 10, the word lines 18 and the thin insulating layers 20. Through-hole conductors 24 are arranged in through-holes in the thick insulating layer 22. The lower end of each through-hole conductor 24 abuts on source/drain regions 26 within the active area 14. Those parts of the active area 14 arranged between source/drain regions 26 and directly under gates 18 are channel regions 28. Horizontal beam-shaped first and second electrode bars 30, 32 are arranged at and electrically conductively connected to the upper ends of the through-hole conductors 24. The ends of the electrode bars 30, 32 form first and second electrodes 34, 36. Each second electrode 36 is arranged vertically above a first electrode 34. A storing material 38 is arranged between each pair of first and second electrodes 34, 36. As an example, the first electrodes 34 are made of an electrochemically active material and the second electrodes 36 are made of a chemically inert material as already described above. The storing material 38 is an electrically insulating matrix with small regions or islands of an electrically conductive material.

The source/drain regions 26, the channel regions 28 and the word lines 18 form transistors 42, the word lines 18 serving as gate-electrodes. The conductivities of the channel regions 28 are controlled via voltages applied to the word lines 18. Each storing material 38 together with the adjacent first and second electrodes 34, 36 form a resistive storage element 44. The arrangement of the first and second electrodes 34, 36 and the storing material 38 is such that the direction of the electrical field and of the electrical current within the storing material 38 of each storage element 44 is vertical to the surface 12 of the substrate 10. Therefore, the storage elements 44 are called vertical.

As can be easily seen from Figure 20, the geometry of the conventional CBRAM device is rather complicated causing high manufacturing costs.

WO 2005/117026 A1 describes a resistive memory cell arrangement similar to the circuit described above.

US 2003/0137869 A1 describes a programmable microelectronic device with a horizontal configuration comprising electrodes and ion conductor portions between the electrodes.

EP 1 429 342 A1 describes a data storage device with a plurality of vertically oriented magneto-resistive or phase-change memory elements.

US 2004/0056286 A1 describes a memory architecture with memory cell groups, each memory cell comprising a bottom electrode and a top electrode and a ferroelectric layer between these electrodes.

US 2002/0097598 A1 describes an MRAM device comprising magnetic memory storage cells coupled together in series with switches coupled in parallel to each magnetic memory storage cell.

US 2004/0017706 A1 describes a MRAM configuration containing a multiplicity of memory cells which are disposed in a memory matrix and each of which contains at least one magnetic tunnel junction layer sequence and a selection transistor. The layer sequence is arranged in a vertical direction.

G. Muller et al. describe in "Status and outlook of emerging nonvolatile memory technologies" (IEDM Technical Digest 2004, pages 567-570) a conductive bridging RAM comprising stacks of a vertical sequence of layers in each storage cell.

### Summary of the invention

It is one of the objects of the present invention to provide a microelectronic device which can be manufactured more easily and generates lower manufacturing costs. It is another object of the present invention to provide a microelectronic device with a plurality of storage elements in serial connection and a plurality of transistors each transistor being connected parallel to one of the plurality of storage elements. It is a further object of the present invention to provide a microelectronic device each storage element of which providing two different electrodes made of different materials. It is a further object of the present invention to provide a microelectronic device the storage elements of which are resistive storage elements. It is a further object of the present invention to provide a method of producing a microelectronic device.

These and other objects are achieved by the microelectronic devices according to claims 1 and 3 and by the method according to claim 10.

Preferred embodiments of the present invention are defined in the dependent claims.

The present invention refers to microelectronic devices with storage elements each of which comprising a storage material between two different electrodes. The present invention is based on the idea to arrange these storage elements horizontally, i.e. the direction of the electrical field and the direction of any current flowing in the storage elements are essentially parallel to the surface of the substrate of the microelectronic device. Furthermore, the present invention is based on the idea to arrange resistive storage elements of a microelectronic device horizontally. Thereby, the geometry and the manufacturing costs of the microelectronic device are reduced considerably.

Further, the present invention is based on the idea to produce a storage element of a microelectronic device by producing a cavity in an insulating layer thereby uncovering a part of an essentially vertical side wall of each of a first and second conductor made of a first electrode material and to deposit a second electrode material on the uncovered part of the vertical side wall of one of these through-hole conductors. After the deposition of the second electrode material a storing material is deposited in the cavity. Particularly, the present invention is based on the idea to deposit the second electrode material by means of vapour-deposition or by a sputtering process or by an implantation of atoms transforming the first electrode material to the second electrode material wherein the direction from the source to the surface of the substrate is non-vertical to the surface.

The present invention considerably reduces the complexity of the geometry and of the manufacturing procedure and correspondingly reduces the manufacturing costs of a microelectronic device with storage elements in a chain architecture. It is a further advantage of the present invention that each single storage cell requires only 4F² of chip area, wherein F is the minimum linear dimension. The storage states of the storing material of the storage elements are preferably changed and sensed electrically. Preferably the storage states of the storing material are permanent, or non-volatile and can be changed once in a single programming process (like in ROM device) or multiple times (like in RAM devices). Alternatively the storage states are volatile.

### Brief description of the drawings

These and other objects and features of the present invention will become clear from the following description taken in conjunction with the accompanying drawings in which:
- Figures 1 to 9: are schematic views of a microelectronic device during a manufacturing process;
- Figure 10: is a schematic circuit diagram of the microelectronic device;
- Figure 11: is a schematic top view of the microelectronic device;
- Figures 12 to 16: are schematic views of an embodiment of the present invention during a manufacturing process;
- Figure 17: is a schematic circuit diagram of the embodiment;
- Figure 18: is a schematic top view of the embodiment;
- Figure 19: is a schematic flow-chart of a method according to the present invention;
- Figure 20: is a schematic view of a conventional microelectronic device; and
- Figure 21: is a schematic circuit diagram of a conventional microelectronic device.

### Description of microelectronic devices and the preferred embodiments

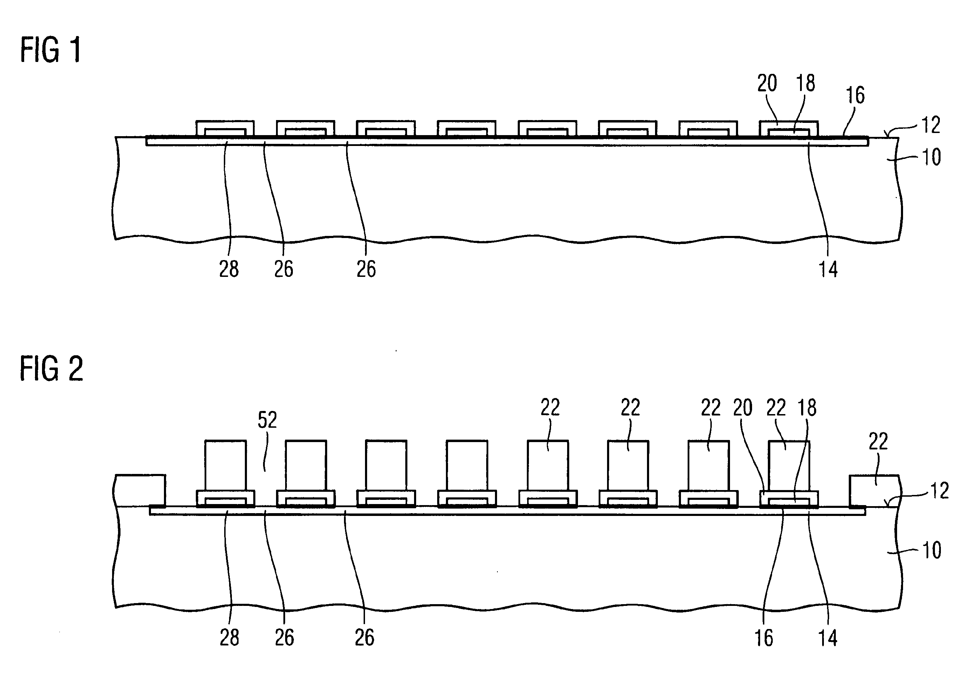

Figures 1 to 9 display schematic views of vertical cross sections of a microelectronic device.

The microelectronic device is a memory device, preferably a non-volatile memory device, or any other microelectronic device comprising storage elements. For example, the microelectronic device is a processor with integrated cache or with an integrated non-volatile memory block. The storage elements are formed at the surface 12 of a substrate 10. The cross sectional area displayed in Figures 1 through 9 is vertical to the surface 12 of the substrate 10.

Referring to Figure 1, an active area 14 is formed at the surface 12 in the substrate 10. An oxide layer 16 later on serving as a gate oxide layer is deposited on the active area. Strip-shaped word lines 18 made of an electrically conductive material are formed on the oxide layer 16. The word lines 18 are arranged parallel to the surface 12 of the substrate 10 and perpendicular to the cross-sectional area displayed in the Figures 1 through 9. The word lines 18 are covered with a thin electrically insulating layer 20. Thereby each word line is encapsulated by the oxide layer 16 and the thin electrically insulating layer 20. Those parts of the active area 14 positioned directly beneath the word lines 18 are channel regions 28. Those parts of the active area 14 arranged between the word lines 18 are source/drain regions 26.

Referring to Figure 2, a thick electrically insulating layer 22 is deposited over the surface 12 of the substrate 10 and over the word lines 18 and the thin electrically insulating layer 20. The thick electrically insulating layer 22 is laterally structured lithographically thereby producing openings, or vias, or through holes 52. The material of the thin electrically insulating layer 20, the material of the thick electrically insulating layer 22 and the etching process are selected such that the thin electrically insulating layer 20 is not worn. Thereby, the through-holes 52 are self-aligned with respect to the word lines 18 in the direction perpendicular to the word lines 18. The through-holes 52 completely penetrate the thick electrically insulating layer 22 and the gate oxide layer 16.

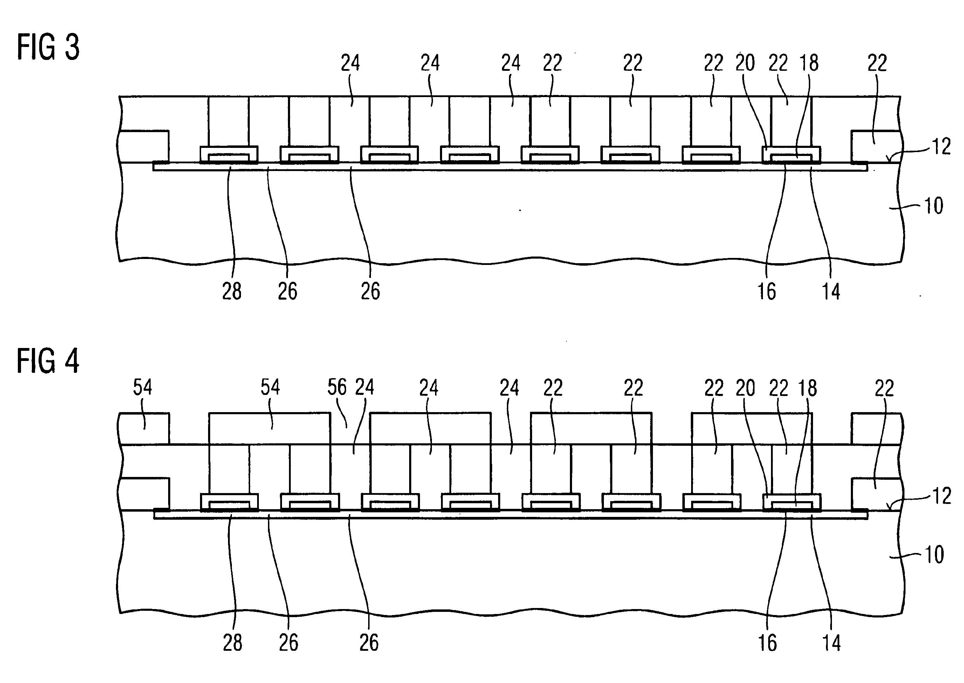

Referring to Figure 3, the vias or through-holes 52 are filled with an electrically conductive material thereby forming through-hole conductors 24. The situation displayed in Figure 3 is for example achieved by depositing the electrically conductive material with a subsequent CMP-step (CMP = Chemical Mechanical Polishing). The lower ends of the vertical through-hole conductors 24 abut on the surface 12 of the substrate 10 and thereby are electrically conductively connected to the source/drain regions 26.

Referring to Figure 4, another electrically insulating layer 54 is deposited and laterally structured by lithography, thereby producing openings 56. These openings 56 are laterally aligned with every second through-hole 24 and abut on their upper ends.

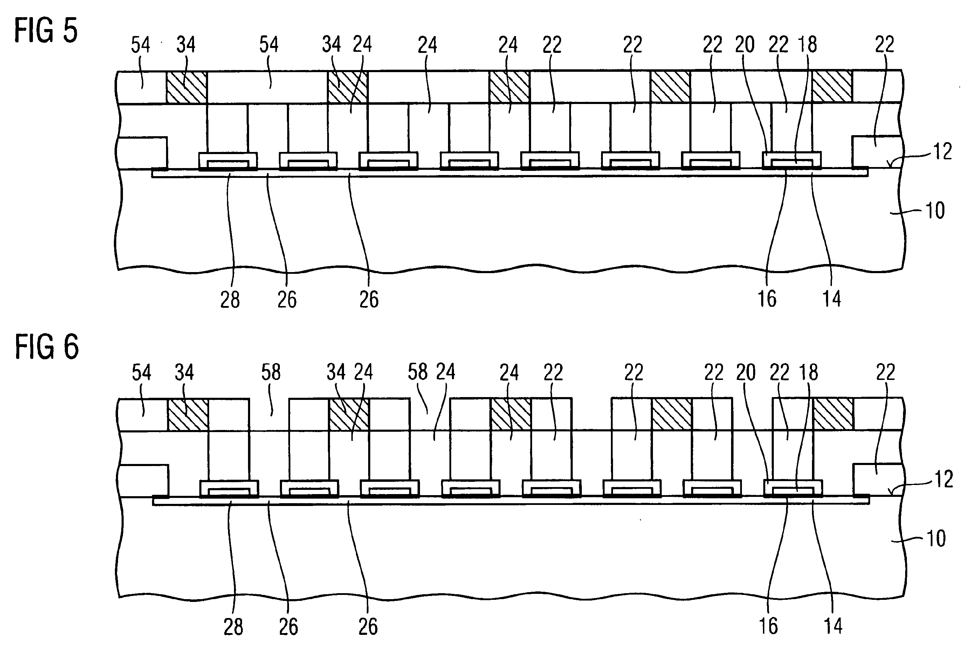

Referring to Figure 5, the openings 56 are filled with a first electrode material thereby forming first electrodes 34 electrically conductively connected with the upper ends of every second vertical through-hole conductor 24. This is done by a deposition step and a subsequent polishing step or electro-chemically or by any other suitable method.

Referring to Figure 6, openings 58 are produced in the electrically insulating layer 54 lithographically. These openings 58 are laterally aligned with and abut on those vertical through-hole conductors 24 not connected to a first electrode 34.

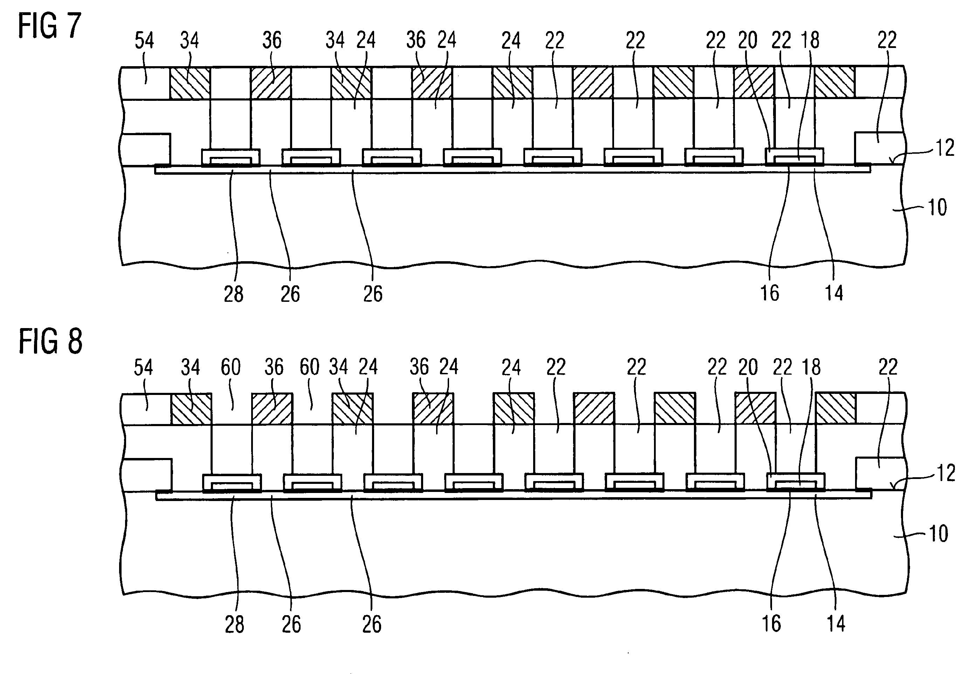

Referring to Figure 7, the openings 58 are filled with a second electrode material thereby forming second electrodes 36 electrically conductively connected with every second vertical through-hole conductor 24. The same methods as described above with reference to the first electrodes 34 can be used for the production of the second electrodes 36.

Referring to Figure 8, cavities 60 are produced in the electrically insulating layer 54. Each cavity 60 uncovers a part of the essentially vertical side wall of a first electrode 34 and a part of the essentially vertical side wall of a second electrode 36. The etching process used for the production of the openings 60 preferably does not wear the material of the thick electrically insulating layer 22. Further, the etching process preferably does not wear the first and second electrode materials of the first and second electrodes 34, 36. Thereby, the cavities 60 are self-aligned in the direction perpendicular to the word lines 18.

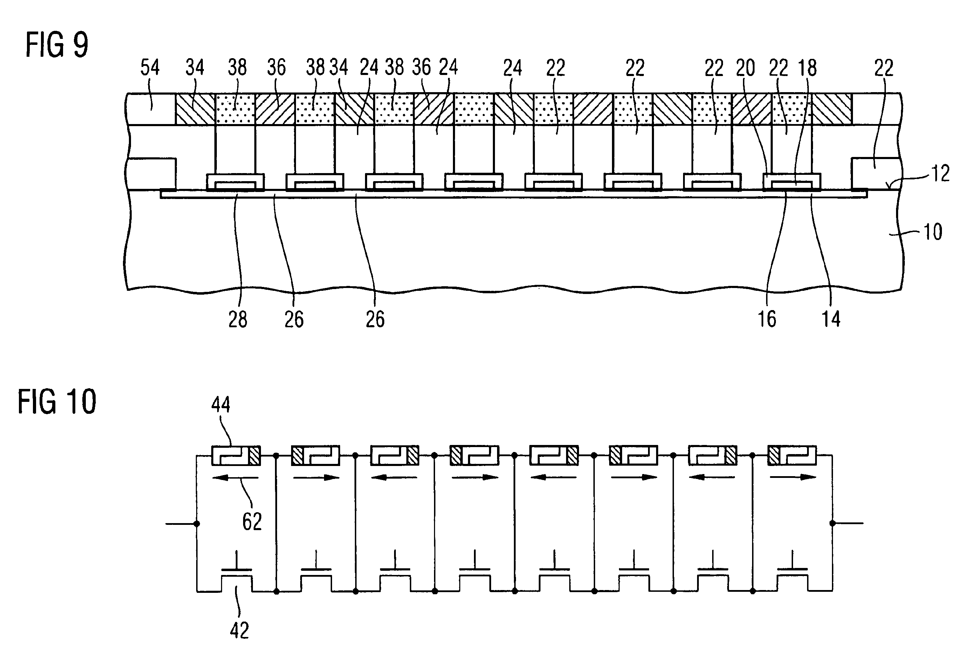

Referring to Figure 9, the cavities 60 are filled with a storing material 38. The storing material 38 comprises an electrically insulating matrix, for example GeSe or an other chalcogenide. An electrically conductive material is diffused into the electrically insulating matrix and forms electrically conductive regions or islands within the electrically insulating matrix. The diffusion is photon-assisted. Alternatively any other methods may be used for the production of the storing material 38.

Figure 10 displays a schematic circuit diagram of the chain of storage elements produced by the above-described method. Each storing material 38 together with the adjacent first electrode 34 and the adjacent second electrode 36 form a resistive storage element 44. The resistive storage elements 44 are connected in series. Each channel region 28 together with the adjacent source/drain regions 26 forms a transistor 42. Each transistor 42 is connected parallel to a storage element 44 via through-hole conductors 24. The word lines 18 control the electrical conductivities of the transistors 42 and their channel regions 28.

Either the first or the second electrode material is a chemically inert material which does not take part in any chemical reaction during the programming process of the storage element 44. One example is tungsten (W). The other electrode material is an active material like silver (Ag). The application of a voltage above a predefined threshold to a storage element 44 starts an electrochemical reaction at the active electrode and drives ions into the insulating matrix. Thereby the conductive islands are increased and finally form a conductive bridge between the first and second electrodes 34, 36 reducing the electrical resistance of the storage element 44 by several orders of magnitude. A typical ON resistance is in the order of 10⁵ Ω.

An inverse voltage below a second (negative) threshold drives ions back to the active electrode and reverses the electrochemical reaction at the active electrode. The conductive islands are reduced and finally the conductive bridge is destroyed. The electrical resistance of the storage element 44 is increased by several orders of magnitude. A typical OFF resistance is in the order of 10¹⁰ Ω ... 10¹¹ Ω.

The low ON resistance would cause an extreme current density destroying the storage element. Therefore, the current is preferably limited by a current limiting circuit not displayed in the Figures. Typically a voltage below 1 V (for example 220 mV) is used for writing a bit into a storage element by changing its conductivity state. The conductivity state is sensed and the bit stored in the storage element is read by the application of an even lower voltage (for example 100 mV) and the detection of the current flowing at this voltage.

During the access to a certain one of the storage elements 44, the corresponding transistor 42 is switched off and all the other transistors are switched on by the application of predefined voltages to the word lines 18. As can be seen from Figures 9 and 10, the polarity of the storage elements 44 is alternating along the serial connection. In Figure 10 this fact is represented by the circuit symbols of the storage elements 44 and by arrows 62. Due to this alternating polarity the write and read circuit needs to be connected to the chain of storage elements 44 in two different ways. In other words, the polarity of the writing and reading voltages and currents need to be reversed from storage element to storage element.

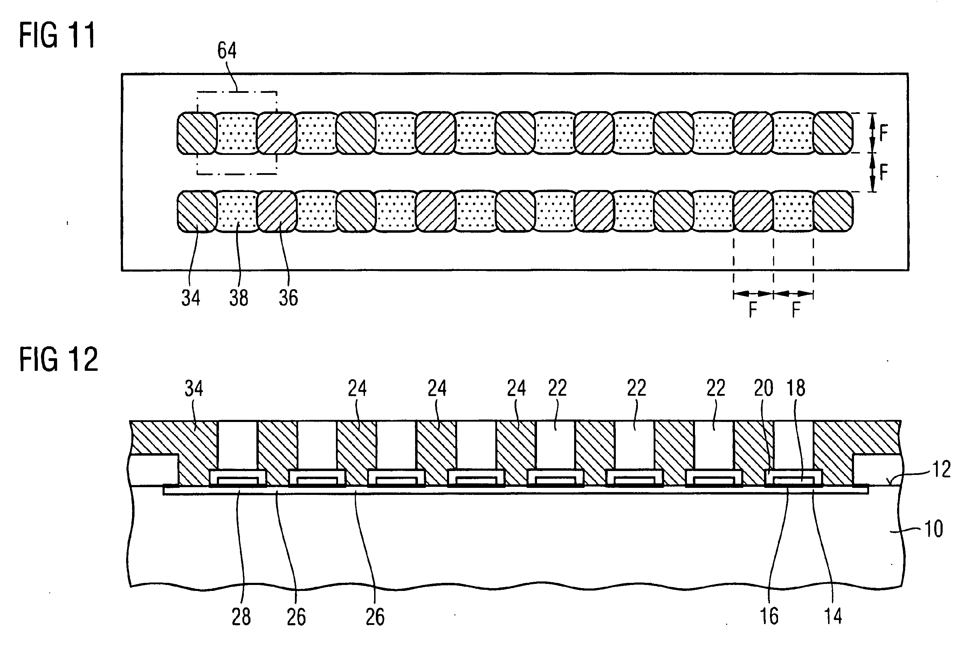

Figure 11 is a schematic top view of the storage element displayed in Figure 9. The linear dimensions of each first and second electrodes 34, 36 and their respective distances equal the minimum size F of any structure which can be produced by the respective technology. The broken line frame 64 indicates the size of one storage cell. As can be easily seen, the lateral area of each storage cell is 4F². The microelectronic device provides very small storage cells and low manufacturing costs.

It is obvious that the microelectronic device described with reference to Figures 1 through 11 can be applied to the PCRAM technology and to memory technologies with other resistive storage elements as well, wherein each storage element comprises two electrodes made of the same material or made of two different materials.

The microelectronic device can be modified in many ways. For example the openings 56, 58 can be produced by selectively etching the upper ends of through hole conductors 24, which is a self aligned process. Further, at least the first electrodes 34 or the second electrodes 36 can be made integral with the respective through hole conductors 24.

The manufacturing process of a microelectronic device according to an embodiment of the present invention is now described with reference to Figures 12 through 16. Like the Figures 1 trough 9, Figures 12 through 16 display schematic views of a cross-section vertical to the surface 12 of a substrate 10.

The first steps of the manufacturing process are similar to the steps described above with reference to Figures 1 to 3. However, as can be seen from Figure 12, the electrically conductive material forming the through-hole conductors 24 is the first electrode material. Thus, the upper ends of the through-hole conductors 24 will form the first electrodes 34. In other words, the first electrodes 34 are integral with the through-hole conductors 24.

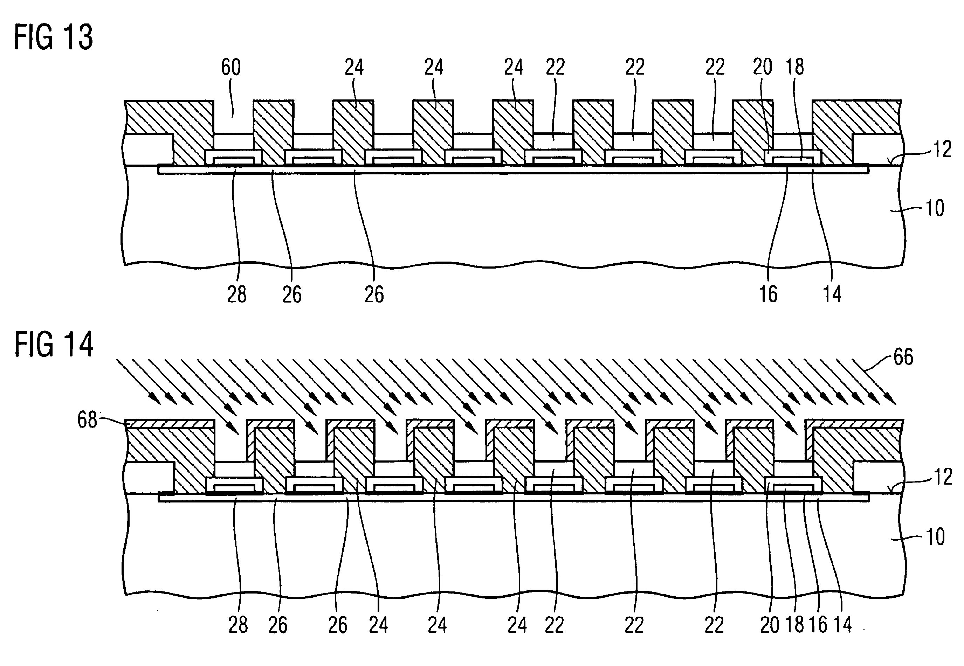

Referring to Figure 13, cavities 60 are produced in the thick electrically insulating layer 22 by lithography. Each cavity 60 uncovers parts of the essentially vertical side walls of two adjacent vertical through-hole conductors 24.

Referring to Figure 14, a second electrode material is deposited by vapour deposition or by a sputtering process. As indicated by the arrows 66, the direction from the source of the second electrode material to the substrate 10 is not vertical to the surface 12 of the substrate. The angle of incidence of the second electrode material is selected such that in each cavity 60 the second electrode material is only deposited on the vertical side wall of one of the adjacent vertical through-hole conductors 24, while the uncovered parts of the vertical side walls of the other through-hole conductor 24 adjacent to the same cavity is shadowed and therefore not covered for the second electrode material. The resulting second electrode material layer 68 is displayed in Figure 14.

It is noted that when the second electrode material is the electrochemically active material, it is not necessary to produce a solid layer 68 as displayed in Figure 14. Rather, a small amount of the active electrode material on the vertical side wall of one of the through-hole conductors 24 adjacent to each cavity 60 is sufficient.

Instead of depositing the second electrode material on the surface of the first electrode material of the vertical through-hole conductors 24, the first electrode material can be modified by implantation and thereby be transformed to the second electrode material.

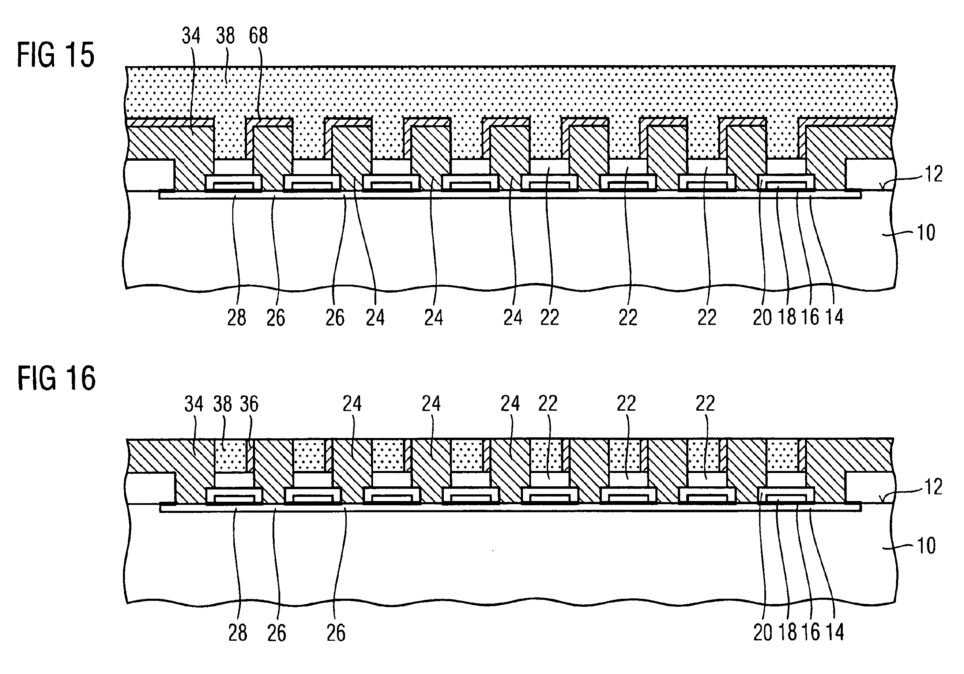

Referring to Figure 15, the storing material 38 is deposited in the cavity 60 and over the vertical through-hole conductors 24. This is done in a similar way as described above with reference to Figure 9.

Referring to Figure 16, the surplus storing material 38 outside the cavities 60 and the horizontal parts of the second electrode material layer 68 on top of the through-hole conductors 24 are removed by a CMP-step. The geometry produced with the above described method and displayed in Figure 16 comprises a number of storage cells, each storage cell comprising a storing material 38, a first electrode 34 and an interface between the first electrode 34 and the storing material 38. The first electrode 34 of each storage cell comprises a backside opposite to the interface between the first electrode 34 and the storing material 38. The second electrode 36 of a second storage cell (in Figure 16: on the left hand side of the first storage cell) is arranged on the backside of the first electrode 34 of the first storage cell.

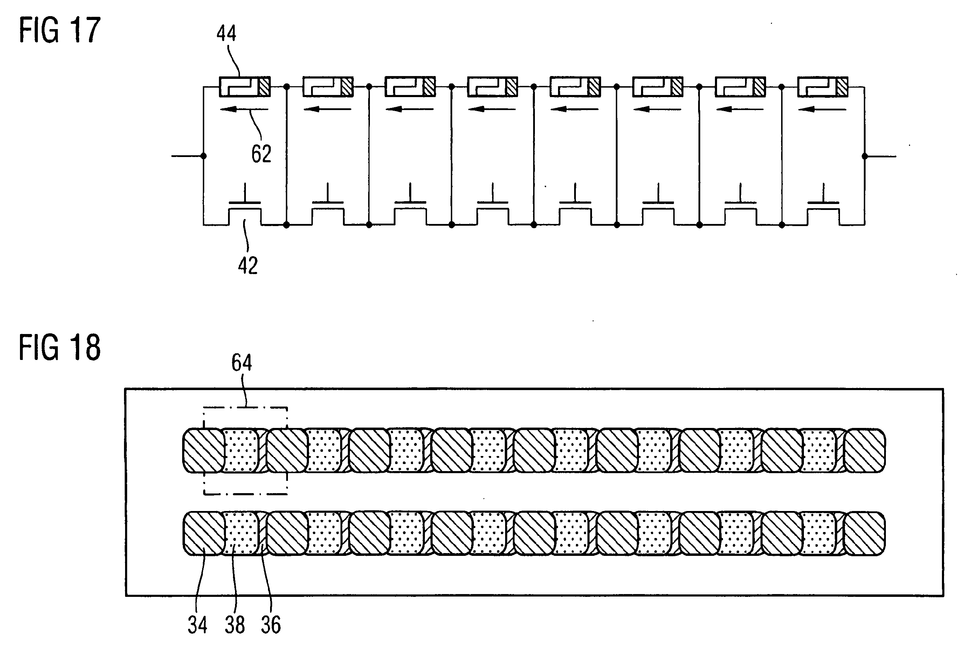

Figure 17 displays a schematic circuit diagram of the microelectronic device produced by the above-described process and displayed in Figure 16. As can be easily seen, the polarities of all the storage elements 44 are equal. This means that the polarities of voltages and currents applied to or sensed at any storage element 44 during writing or reading, respectively, are equal for all storage elements 44. Thereby, the complexity of the writing and reading circuits is reduced considerably. Further, the complexity of the manufacturing process and hence the manufacturing costs are reduced considerably.

Referring to Figure 18, a schematical top view of the embodiment is displayed. Again, the lateral area of one storage cell is 4F². The same electrode materials (e. g. W and Ag) and the same storing material (e. g. GeSe with Ag islands) can be used as in the microelectronic device described above with reference to Figures 1 through 11.

It is obvious that the embodiment is advantageous not only for a resistive storing material 38 but for all storage elements 44 comprising two different electrodes, wherein the storage states of the storing material are preferably changed and sensed electrically.

Furthermore, the method of manufacturing the storage cell, particularly the production of the second electrode by means of a source positioned non-vertical to the surface 12 of the substrate 10 is not limited to the chain architecture of the embodiment. Rather, any storage element with two different electrodes and any other microelectronic element with two different electrodes can be produced by this method advantageously.

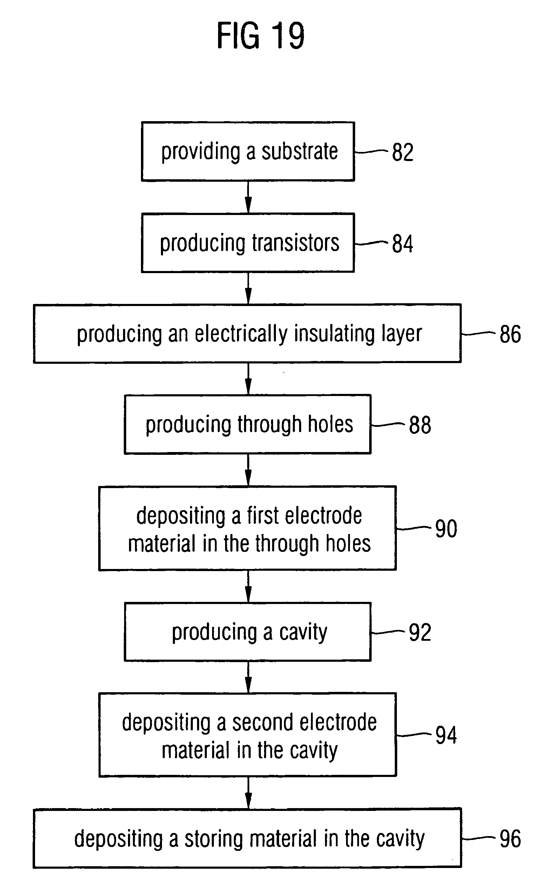

Figure 19 is a schematic flow-chart of a method of producing a microelectronic device according to the present invention. In a first step 82, a substrate 10 with a surface 12 is provided. In a second step 84, a plurality of transistors 42 with source and drain electrodes 26 are produced at the surface of the substrate. The source electrode of a first one of the plurality of transistors 42 is connected with a drain electrode of a second one of the plurality of transistors 42. In a third step 86, an electrically insulating layer 22 is produced over the plurality of transistors 42. In a fourth step 88, a plurality of through-holes 52 is produced in the insulating layer 22. Each through-hole abuts on the source electrode of one of the plurality of transistors 42 and on the drain electrode of another one of the plurality of transistors 42. In a fifth step 90 a first electrode material is deposited in the plurality of through-holes 52 thereby producing vertical through-hole conductors 24.

In a sixth step 92 a cavity is produced in the insulating layer 22, thereby uncovering a part of an essentially vertical side wall of a first one of the through-hole conductors 24 and a part of an essentially vertical side wall of a second one of the through-hole conductors. In a seventh step 94 in each cavity a second electrode material is deposited on the uncovered part of the essentially vertical side wall of one of the through-hole conductors contiguous to the cavity. In an eighth step 96 the storing material 38 is deposited in the cavity the storing material providing at least two different storing states with different electrical properties.

### List of reference numerals

- 10: substrate
- 12: surface of the substrate 10
- 14: active area
- 16: oxide layer
- 18: word line
- 20: thin electrically insulating layer
- 22: thick electrically insulating layer
- 24: through hole conductor
- 26: source/drain region
- 28: channel region
- 30: first electrode bar
- 32: second electrode bar
- 34: first electrode
- 36: second electrode
- 38: storing material
- 42: transistor
- 44: storage element
- 52: opening
- 54: electrically insulating layer
- 56: opening
- 58: opening
- 60: cavity
- 62: arrow
- 64: frame
- 66: arrow
- 68: second electrode material layer
- 82: first step
- 84: second step
- 86: third step
- 88: fourth step
- 90: fifth step
- 92: sixth step
- 94: seventh step
- 96: eighth step

## Claims

1. Microelectronic device comprising:
a substrate (10) with a surface (12);
a plurality of storage elements (44) in serial connection formed at the surface (12) of the substrate (10), each storage element (44) comprising a storing material (38) between a first electrode (34) and a second electrode (36), the storing material (38) providing at least two different storing states with different electrical properties, the first electrode (34) comprising a first material and the second electrode (36) comprising a second material different from the first material; and
a plurality of transistors (42), each transistor being connected parallel to one of the plurality of storage elements (44),
wherein each of the plurality of storage elements (44) is so oriented that a direction of an electrical field and a direction of a current flowing in the respective storage element (44) are essentially parallel to the surface (12) of the substrate (10),
the first electrode (34) of a first storage element (44) has an essentially vertical backside opposite to the interface between the first electrode (34) of the first storage element (44) and the storing material (38) of the first storage element (44), and
the material of the second electrode (36) of a second storage element (44) is deposited on the backside of the first electrode (34) of the first storage element (44).

2. Microelectronic device according to claim 1, wherein
the storing material (38) is a resistive material, and
the at least two different storing states of the storing material (38) are resistive states with different resistive values.

3. Microelectronic device comprising:
a substrate (10) with a surface (12);
a plurality of resistive storage elements (44) in serial connection formed at the surface (12) of the substrate (10), each resistive storage element (44) comprising a resistive material (38) between two electrodes (34, 36), the resistive material providing at least two different resistive states with different electrical resistance values; and
a plurality of transistors (42), each transistor (42) being connected parallel to one of the plurality of resistive storage elements (44),
wherein each of the plurality of resistive storage elements (44) is so oriented that a direction of an electrical field and a direction of a current flowing in the respective storage element (44) are essentially parallel to the surface (12) of the substrate (10),
the first electrode (34) of a first storage element (44) has an essentially vertical backside opposite to the interface between the first electrode (34) of the first storage element (44) and the storing material (38) of the first storage element (44), and
the material of the second electrode (36) of a second storage element (44) is deposited on the backside of the first electrode (34) of the first storage element (44).

4. Microelectronic device according to claim 3, wherein
each resistive storage element (44) comprises the resistive storing material (38) between a first electrode (34) and a second electrode (36), and
the first electrode (34) comprises a first material and the second electrode (36) comprises a second material different from the first material.

5. Microelectronic device according to one of the claims 1 to 4, wherein the interfaces between the first and second electrodes (34, 36) and the storing material (38) are essentially vertical to the surface (12) of the substrate (10).

6. Microelectronic device according to one of the claims 1 to 5, wherein the second electrode (36) of a first storage element (44) out of the plurality of storage elements (44) adjoins the first electrode (34) of a second storage element (44) out of the plurality of storage elements (44).

7. Microelectronic device according to one of the claims 1 to 6, further comprising:
an insulating layer (22) positioned between the storing material (38) of each storage element (44) and the surface (12) of the substrate (10);
through holes (52) in the insulating layer (22); and
vertical through hole conductors (24), each through hole conductor (24) being positioned in one of the through holes (52),
wherein the first electrode (34) of each of the plurality of resistive storage elements (44) is one end of one of the vertical through hole conductors (24) the other end of which is electrically conductively connected to a source/drain region (26) under the surface (12) of the substrate (10).

8. Microelectronic device according to one of the claims 1 to 7, further comprising:
word lines (18) oriented parallel to the surface (12) of the substrate (12) and perpendicular to the resistive storage elements (44);
active areas (14) under the surface (12) of the substrate (10), each active area (14) being positioned between a pair of through hole conductors (24) connected to the same storage element (44); and
an insulating layer (16) between the active areas (14) and the word lines (18),
wherein the electrical conductivities of the active areas (14) can be switched by the application of predefined voltages to the word lines (18).

9. Microelectronic device according to one of the claims 1 to 8, wherein the memory device is a non-volatile memory device.

10. Method of producing a microelectronic device, the method comprising:
providing (82) a substrate (10) with a surface (12);
producing (86) an electrically insulating layer (22) with two conductors (34) embedded in the insulating layer (22), the conductors (34) comprising a first electrode material; producing a cavity (60) in the insulating layer (22), thereby uncovering a part of an essentially vertical side wall of the first conductor (34) and a part of an essentially vertical side wall of the second conductor (34);
depositing a second electrode (36) material on the uncovered part of the vertical side wall of the second conductor (34); and
depositing a storing material (38) in the cavity (60), the storing material (38) providing at least two different storing states with different electrical properties.

11. Method according to claim 10, wherein
the second electrode material is deposited by means of a vaporisation source or a sputter source, and
the direction from the source to the surface of the substrate is non-vertical to the surface.

## Patentansprüche

1. Mikroelektronische Einrichtung, umfassend:
ein Substrat (10) mit einer Oberfläche (12);
mehrere Speicherelemente (44) in serieller Verbindung an der Oberfläche (12) des Substrats (10) ausgebildet, wobei jedes Speicherelement (44) ein Speichermaterial (38) zwischen einer ersten Elektrode (34) und einer zweiten Elektrode (36) umfaßt, wobei das Speichermaterial (38) mindestens zwei verschiedene Speicherzustände mit verschiedenen elektrischen Eigenschaften bereitstellt, wobei die erste Elektrode (34) ein erstes Material umfaßt und die zweite Elektrode (36) ein von dem ersten Material verschiedenes zweites Material umfaßt; und
mehrere Transistoren (42), wobei jeder Transistor parallel zu einem der mehreren Speicherelemente (44) geschaltet ist,
wobei jedes der mehreren Speicherelemente (44) so orientiert ist, daß eine Richtung eines elektrischen Feldes und eine Richtung eines in dem jeweiligen Speicherelement (44) fließenden Stroms im wesentlichen parallel zur Oberfläche (12) des Substrats (10) verlaufen,
die erste Elektrode (34) eines ersten Speicherelements (44) eine im wesentlichen vertikale Rückseite gegenüber der Grenzfläche der ersten Elektrode (34) des ersten Speicherelments (44) und dem Speichermaterial (38) des ersten Speicherelements (44) aufweist und
das Material der zweiten Elektrode (36) eines zweiten Speicherelements (44) auf der Rückseite der ersten Elektrode (34) des ersten Speicherelements (44) abgeschieden ist.

2. Mikroelektronische Einrichtung nach Anspruch 1, wobei
das Speichermaterial (38) ein resistives Material ist und
die mindestens zwei verschiedenen Speicherzustände des Speichermaterials (38) resistive Zustände mit verschiedenen resistiven Werten sind.

3. Mikroelektronische Einrichtung, umfassend:
ein Substrat (10) mit einer Oberfläche (12);
mehrere resistive Speicherelemente (44) in serieller Verbindung an der Oberfläche (12) des Substrats (10) ausgebildet, wobei jedes resistive Speicherelement (44) ein resistives Material (38) zwischen zwei Elektroden (34, 36) umfaßt, wobei das resistive Material mindestens zwei verschiedene resistive Zustände mit verschiedenen elektrischen Widerstandswerten bereitstellt; und
mehrere Transistoren (42), wobei jeder Transistor (42) parallel zu einem der mehreren resistiven Speicherelemente (44) geschaltet ist,
wobei jedes der mehreren resistiven Speicherelemente (44) so orientiert ist, daß eine Richtung eines elektrischen Feldes und eine Richtung eines in dem jeweiligen resistiven Speicherelement (44) fließenden Stroms im wesentlichen parallel zur Oberfläche (12) des Substrats (10) verlaufen,
die erste Elektrode (34) eines ersten resistiven Speicherelements (44) eine im wesentlichen vertikale Rückseite gegenüber der Grenzfläche der ersten Elektrode (34) des ersten resistiven Speicherelments (44) und dem resistiven Speichermaterial (38) des ersten resistiven Speicherelements (44) aufweist und
das Material der zweiten Elektrode (36) eines zweiten Speicherelements (44) auf der Rückseite der ersten Elektrode (34) des ersten Speicherelements (44) abgeschieden ist.

4. Mikroelektronische Einrichtung nach Anspruch 3, wobei
jedes resistive Speicherelement (44) das resistive Speichermaterial (38) zwischen einer ersten Elektrode (34) und einer zweiten Elektrode (36) umfaßt und
die erste Elektrode (34) ein erstes Material umfaßt und die zweite Elektrode ein von dem ersten Material verschiedenes zweites Material umfaßt.

5. Mikroelektronische Einrichtung nach einem der Ansprüche 1 bis 4, wobei die Grenzflächen zwischen der ersten und zweiten Elektrode (34, 36) und dem Speichermaterial (38) im wesentlichen vertikal zur Oberfläche (12) des Substrats (10) verlaufen.

6. Mikroelektronische Einrichtung nach einem der Ansprüche 1 bis 5, wobei die zweite Elektrode (36) eines ersten Speicherelements (44) unter den mehreren Speicherelementen (44) an die erste Elektrode (34) eines zweiten Speicherelements (44) unter den mehreren Speicherelementen (44) angrenzt.

7. Mikroelektronische Einrichtung nach einem der Ansprüche 1 bis 6, weiterhin umfassend:
eine zwischen dem Speichermaterial (38) jedes Speicherelements (44) und der Oberfläche (12) des Substrats (10) positionierte Isolierschicht (22);
Durchgangslöcher (52) in der Isolierschicht (22); und
vertikale Durchgangslochleiter (24), wobei jeder Durchgangslochleiter (24) in einem der Durchgangslöcher (52) positioniert ist,
wobei die erste Elektrode (34) jedes der mehreren resistiven Speicherelemente (44) ein Ende eines der vertikalen Durchgangslochleiter (24) ist, dessen anderes Ende elektrisch leitend mit einem Source-/Draingebiet (26) unter der Oberfläche (12) des Substrats (10) verbunden ist.

8. Mikroelektronische Einrichtung nach einem der Ansprüche 1 bis 7, weiterhin umfassend:
parallel zur Oberfläche (12) Substrats (10) und senkrecht zu den resistiven Speicherelementen (44) orientierte Wortleitungen (18);
aktive Bereiche (14) unter der Oberfläche (12) des Substrats (10), wobei jeder aktive Bereich (14) zwischen einem Paar von an das gleiche Speicherelement (44) angeschlossener Durchgangslochleiter (24) positioniert ist; und
eine isolierende Schicht (16) zwischen den aktiven Bereichen (14) und den Wortleitungen (18),
wobei die elektrischen Leitfähigkeiten der aktiven Bereiche (14) durch das Anlegen von vordefinierten Spannungen an die Wortleitungen (18) umgeschaltet werden können.

9. Mikroelektronische Einrichtung nach einem der Ansprüche 1 bis 8, wobei die Speichereinrichtung eine nichtflüchtige Speichereinrichtung ist.

10. Verfahren zum Herstellen einer mikroelektronischen Einrichtung, wobei das Verfahren folgendes umfaßt:
Bereitstellen (82) eines Substrats (10) mit einer Oberfläche (12);
Herstellen (86) einer elektrisch isolierenden Schicht (22) mit zwei in die isolierende Schicht (22) eingebetteten Leitern (34), wobei die Leiter (34) ein erstes Elektrodenmaterial umfassen;
Herstellen eines Hohlraums (60) in der isolierenden Schicht (22), um **dadurch** einen Teil einer im wesentlichen vertikalen Seitenwand des ersten Leiters (34) und einen Teil einer im wesentlichen vertikalen Seitenwand des zweiten Leiters (34) freizulegen;
Abscheiden eines zweiten Elektroden-(36)-Materials auf dem freigelegten Teil der vertikalen Seitenwand des zweiten Leiters (34); und
Abscheiden eines Speichermaterials (38) in dem Hohlraum (60), wobei das Speichermaterial (38) mindestens zwei verschiedene Speicherzustände mit unterschiedlichen elektrischen Eigenschaften bereitstellt.

11. Verfahren nach Anspruch 10, wobei
das zweite Elektrodenmaterial mit Hilfe einer Verdampfungsquelle oder einer Sputterquelle abgeschieden wird und
die Richtung von der Quelle zur Oberfläche des Substrats nicht-vertikal zur Oberfläche verläuft.

## Revendications

1. Dispositif microélectronique comprenant :
un substrat (10) ayant une surface (12) ;
une pluralité d'éléments (44) de mémoire en série formés à la surface (12) du substrat (10), chaque élément (44) de mémoire comprenant un matériau (38) de mémorisation entre une première électrode (34) et une deuxième électrode (36), le matériau (38) de mémorisation procurant au moins deux états de mémorisation différents ayant des propriétés électriques différentes, la première électrode (34) comprenant un premier matériau et la deuxième électrode (36) comprenant un deuxième matériau différent du premier matériau ; et
une pluralité de transistors (42), chaque transistor étant monté en parallèle avec l'un de la pluralité d'éléments (44) de mémoire ;
dans lequel chacun de la pluralité d'éléments (44) de mémoire est orienté de façon à ce qu'une direction d'un champ électrique et une direction d'un passage de courant dans l'élément (44) de mémoire respectif soient sensiblement parallèles à la surface (12) du substrat (10) ;
la première électrode (34) d'un premier élément (44) de mémoire a un côté arrière essentiellement vertical opposé à l'interface entre la première électrode (34) du premier élément (44) de mémoire et le matériau (38) de mémorisation du premier élément (44) de mémoire ; et
le matériau de la deuxième électrode (36) d'un deuxième élément (44) de mémoire est déposé sur le côté arrière de la première électrode (34) du premier élément (44) de mémoire.

2. Dispositif microélectronique suivant la revendication 1, dans lequel
le matériau (38) de mémorisation est un matériau résistant ; et
les au moins deux états de mémorisation différents du matériau (38) de mémorisation sont des états résistants ayant des valeurs différentes de la résistance.

3. Dispositif microélectronique comprenant :
un substrat (10) ayant une surface (12) ;
une pluralité d'éléments (44) résistants de mémoire en série formés à la surface (12) du substrat (10), chaque élément (44) résistant de mémoire comprenant un matériau (38) résistant entre deux électrodes (34, 36), le matériau résistant procurant au moins deux états résistants différents ayant des valeurs différentes de la résistance électrique ; et
une pluralité de transistors (42), chaque transistor étant monté en parallèle avec l'un de la pluralité d'éléments (44) résistants de mémoire ;
dans lequel chacun de la pluralité d'éléments (44) résistants de mémoire est orienté de façon à ce qu'une direction d'un champ électrique et une direction d'un passage de courant dans l'élément (44) résistant de mémoire respectif soient sensiblement parallèles à la surface (12) du substrat (10) ;
la première électrode (34) d'un premier élément (44) de mémoire a un côté arrière essentiellement vertical opposé à l'interface entre la première électrode (34) du premier élément (44) de mémoire et le matériau (38) de mémorisation du premier élément (44) de mémoire ; et
le matériau de la deuxième électrode (36) d'un deuxième élément (44) de mémoire est déposé sur le côté arrière de la première électrode (34) du premier élément (44) de mémoire.

4. Dispositif microélectronique suivant la revendication 3, dans lequel
chaque élément (44) résistant de mémoire comprend le matériau (38) résistant de mémorisation entre une première électrode (34) et une deuxième électrode (36) ; et
la première électrode (34) comprend un premier matériau et la deuxième électrode (36) comprend un deuxième matériau différent du premier matériau.

5. Dispositif microélectronique suivant l'une quelconque des revendications 1 à 4, dans lequel les interfaces entre les première et deuxième électrodes (34, 36) et le matériau (38) de mémorisation sont sensiblement verticales par rapport à la surface (12) du substrat (10).

6. Dispositif microélectronique suivant l'une quelconque des revendications 1 à 5, dans lequel la deuxième électrode (36) d'un premier élément (44) de mémoire parmi la pluralité d'éléments (44) de mémoire est adjointe à la première électrode (34) d'un deuxième élément (44) de mémoire parmi la pluralité d'éléments (44) de mémoire.

7. Dispositif microélectronique suivant l'une quelconque des revendications 1 à 6 comprenant en outre :
une couche (22) isolante interposée entre le matériau (38) de mémorisation de chaque élément (44) de mémoire et la surface (12) du substrat (10) ;
des trous (52) traversants dans la couche (22) isolante ; et
des conducteurs (24) verticaux de trous traversants, chaque conducteur (24) de trous traversants étant mis dans l'un des trous (52) traversants dans lequel la première électrode (34) de chacun de la pluralité d'éléments (44) résistants de mémoire est une extrémité de l'un des conducteurs (24) verticaux de trous traversants dont l'autre extrémité est reliée d'une manière conductrice de l'électricité à une région (26) de source/drain sous la surface (12) du substrat (10).

8. Dispositif microélectronique suivant l'une quelconque des revendications 1 à 7 comprenant en outre :
des lignes (18) de mots orientées parallèlement à la surface (12) du substrat (10) et perpendiculairement aux éléments (44) résistants de mémoire ;
des zones (14) actives sous la surface (12) du substrat (10), chaque zone (14) active étant placée entre une paire de conducteurs (24) de trous traversants reliés au même élément (44) de mémoire ; et
une couche (16) isolante entre les zones (14) actives et les lignes (18) de mots,
dans lequel les conductivités électriques des zones (14) actives peuvent être commutées par l'application de tensions définies à l'avance aux lignes (18) de mots.

9. Dispositif microélectronique suivant l'une quelconque des revendications 1 à 8, dans lequel le dispositif de mémoire est un dispositif de mémoire non volatile.

10. Procédé de production d'un dispositif microélectronique dans lequel :
on se procure (82) un substrat (10) ayant une surface (12) ;
on produit (86) une couche (22) isolante du point de vue électrique ayant deux conducteurs (34) incorporés dans la couche (22) isolante, les conducteurs (34) comprenant un premier matériau d'électrode ;
on produit une cavité (60) dans la couche (22) isolante en découvrant ainsi une partie d'une paroi latérale sensiblement verticale du premier conducteur (34) et une partie d'une paroi latérale essentiellement verticale du deuxième conducteur (34) ;
on dépose un matériau de deuxième électrode (36) sur la partie découverte de la paroi latérale verticale du deuxième conducteur (34) ; et
on dépose un matériau (38) de mémorisation dans la cavité (60), le matériau (38) de mémorisation procurant au moins deux états différents ayant des propriétés électriques différentes.

11. Procédé suivant la revendication 10, dans lequel
on dépose le matériau de deuxième électrode au moyen d'une source d'évaporation ou d'une source de pulvérisation cathodique ; et
la direction allant de la source à la surface du substrat n'est pas verticale par rapport à la surface.
